# FASCICULE DE BREVET EUROPEEN

(11) **EP 2 800 151 B1**
(45) Date de publication et mention de la délivrance du brevet: **20.01.2016**
(21) Numéro de dépôt: 14166381.5
(22) Date de dépôt: 29.04.2014
(51) Int. Cl.: H01L 33/10, H01L 33/24, H01L 31/0352, H01L 33/18, H01L 33/46

(54) **Agencement optoélectronique muni d'un nanofil semi-conducteur dont un tronçon longitudinal est entouré par une partie d'un miroir**
Optoelektronische Anordnung, die mit einem Halbleiter-Nanodraht ausgestattet ist, dessen Längsabschnitt von einem Spiegelteil umgeben ist
Optoelectronic arrangement provided with a semiconductor nanowire in which one longitudinal section is surrounded by a mirror portion

(30) Priorité: 02.05.2013 FR 1354060
(43) Date de publication de la demande: 05.11.2014
(73) Titulaire: COMMISSARIAT A L'ENERGIE ATOMIQUE ET AUX ENERGIES ALTERNATIVES, 75015 Paris (FR); CNRS, 75794 Paris Cedex 16 (FR)
(72) Inventeur: Gerard, Jean-Michel, 38410 Saint Martin D'Uriage (FR); Claudon, Julien, 38950 Saint Martin le Vinoux (FR); Lalanne, Philippe, 91120 Palaiseau (FR)
(74) Mandataire: Novaimo

(56) Documents cités:
- US-A1- 2008 149 944
- US-A1- 2010 276 664
- 1. FRIEDLER ET AL.: "Efficient photonic mirrors for semiconductor nanowires", OPTICS LETTERS, vol. 33, no. 22, 15 novembre 2008 (2008-11-15), pages 2635-2637, XP001520927,

## Description

### Domaine technique de l'invention

L'invention concerne le domaine de l'optoélectronique.

L'invention a pour objet plus particulièrement un agencement optoélectronique comprenant un nanofil semi-conducteur.

### État de la technique

Les nanofils à base de semiconducteurs sont reconnus comme étant de bons candidats dans le cadre de la réalisation de dispositifs optoélectroniques.

En effet, la géométrie filaire d'un nanofil permet de construire une grande variété de nano-hétérostructures, et de jouer, dans une large mesure, sur leurs propriétés électroniques et optiques.

On notera qu'il y a deux principales approches pour la fabrication de nanofils, l'approche par une croissance épitaxiale (connue de l'homme du métier de l'anglais « bottom-up »), et l'approche par nanofabrication (connue de l'homme du métier de l'anglais « top-down ») basée en autres sur la lithographie et la gravure.

Pour des applications de masse, pour lesquelles la réduction du coût de fabrication est un enjeu majeur, l'approche par croissance épitaxiale est beaucoup plus attractive.

Parmi les nombreuses applications potentielles des nanofils en optoélectronique et photonique, on retiendra principalement :
- les diodes électroluminescentes,
- les cellules photovoltaïques,
- les sources de photons uniques,

Pour ces applications, l'intégration d'un miroir au niveau de la base des nanofils est particulièrement désirable pour maximiser l'efficacité d'extraction (dans les diodes électroluminescentes et les sources de photons uniques), ou renforcer l'absorption dans les cellules photovoltaïques.

En ce sens, il est connu l'utilisation de miroir planaire qui assure une bonne réflectivité. A titre d'exemple, un film d'or horizontal, placé sous un ensemble de nanofils verticaux de petit diamètre d, permet de réfléchir plus de 90% de la lumière en incidence normale. Un diamètre est considéré comme « petit » s'il est nettement inférieur à la longueur d'onde du rayonnement considéré, par exemple d < 0.3 λ/n, où n désigne l'indice de réfraction du matériau constituant le nanofil.

Un autre cas particulier est celui des nanofils de plus grand diamètre, optimisés pour un guidage efficace de la lumière. Un tel guidage peut être mis en oeuvre lorsque le diamètre du nanofil est approximativement de l'ordre de λ/n, avec λ la longueur d'onde considérée et n l'indice de réfraction du matériau du nanofil. Un tel nanofil ne supporte qu'un mode guidé, qui joue un rôle prépondérant dans ses propriétés optiques. On cherche alors un miroir qui procure un coefficient de réflexion élevé pour le mode guidé. La meilleure solution connue à ce jour est constituée par un miroir plan hybride, formé par une couche d'argent recouverte d'une fine couche de diélectrique tel que décrit dans le document « Efficient photonic mirrors for semiconductor nanowires » de I. Friedler et al. publié dans OPTICS LETTERS le 15 novembre 2008 Vol. 33, No. 22, pages 2635 à 2637.

Le document US2008/149944 A1 décrit un dispositif comprenant un nanofil semiconducteur émettant de la lumière, dont un premier tronçon est entouré par un miroir.

Le gros inconvénient de ces miroirs planaires réside dans le fait qu'ils doivent être intégrés via une étape complexe et coûteuse de report sur un autre substrat que celui qui a servi pour la croissance des nanofils (étape connue de l'homme du métier sous le nom anglais « flip-chip »). De plus, une telle approche ne permet pas à ce jour de reporter de grandes surfaces (300mm de diamètre dans les standards de la microélectronique) de façon fiable et reproductible.

### Objet de l'invention

Le but de la présente invention est de proposer une solution permettant de former un agencement optoélectronique compact, hautement reproductible, et compatible avec une fabrication en grande surface.

On tend vers ce but notamment grâce à un agencement optoélectronique comprenant un nanofil semi-conducteur destiné à participer au traitement, notamment à une réception et/ou une émission, d'une lumière considérée et un miroir réfléchissant à la lumière considérée, le nanofil semi-conducteur comportant un premier tronçon et un deuxième tronçon, et en ce que le miroir entoure au moins longitudinalement le premier tronçon du nanofil semi-conducteur, ledit deuxième tronçon s'étendant hors du miroir.En outre, une ouverture du miroir comblée en tout ou partie par le premier tronçon présente des dimensions latérales d'ouverture inférieures à λ/5n avec n l'indice de réfraction du matériau du premier tronçon du nanofil semi-conducteur, et λ la longueur d'onde de la lumière considérée. L'agencement comporte un substrat sur lequel repose le miroir.

Avantageusement, le nanofil semi-conducteur s'étend, via son premier tronçon, à partir dudit substrat.

De préférence, le miroir comporte une couche réfléchissante à la lumière considérée, notamment la couche réfléchissante comprend un matériau dont le coefficient de réflexion en intensité, à la longueur d'onde considérée et pour une onde plane en incidence normale, est supérieur ou égal à 60% comme par exemple l'or, l'aluminium, le cuivre ou l'argent.

Par ailleurs, le miroir peut comporter une couche tampon transparente à la lumière considérée augmentant la réflectivité du miroir, notamment la couche tampon est en matériau diélectrique comprenant du SiO₂ ou du Si₃N₄, ou en matériau transparent conducteur électriquement tel que l'oxyde d'indium-étain ou l'oxyde de zinc, la couche réfléchissante étant disposée entre le substrat et la couche tampon.

Préférentiellement, la couche réfléchissante présente une épaisseur supérieure à 30nm, et la couche tampon présente une épaisseur comprise entre 2nm et 20nm.

Selon une mise en oeuvre particulière, les sections transversales des premier et deuxième tronçons sont sensiblement identiques.

Selon une autre mise en oeuvre, le deuxième tronçon, disposé dans la continuité du premier tronçon, présente une section transversale dont la surface est supérieure à la surface de la section transversale du premier tronçon de sorte à former un épaulement avec ledit premier tronçon.

Avantageusement, la section transversale du deuxième tronçon au niveau de son interface avec le miroir présente des dimensions supérieures à celles de l'ouverture du miroir comblée en tout ou partie par le premier tronçon.

L'invention est aussi relative à un dispositif optoélectronique qui comporte une pluralité d'agencements tels que décrits, notamment partageant un même miroir, et chaque nanofil semi-conducteur est couplé à des moyens permettant, avec ledit nanofil semi-conducteur, d'émettre ou de recevoir la lumière considérée.

L'invention est aussi relative à un procédé de fabrication d'au moins un agencement tel que décrit, ledit procédé comporte les étapes suivantes :
- la fourniture d'un substrat,
- la réalisation du miroir sur ledit substrat,
- la formation du nanofil semi-conducteur de sorte que le premier tronçon du nanofil semi-conducteur soit entouré au moins longitudinalement par le miroir, et que le deuxième tronçon du nanofil semi-conducteur s'étende hors du miroir.

Par ailleurs, le procédé peut comporter la formation d'une ouverture dans le miroir, l'étape de formation du nanofil semi-conducteur étant réalisée par croissance, notamment par épitaxie, à partir de l'ouverture.

De préférence, l'ouverture est formée de sorte à présenter un fond délimité par le substrat, ou par une partie du miroir, la croissance du nanofil semi-conducteur étant réalisée à partir dudit fond.

Avantageusement, l'étape de formation du miroir, réalisée avant l'étape de formation du nanofil semi-conducteur, comporte le dépôt d'une première couche d'un matériau apte à catalyser la croissance du nanofil semi-conducteur et le dépôt d'une ou plusieurs deuxièmes couches sur la première couche de sorte que le fond de l'ouverture soit formé par une partie de la première couche et que la paroi latérale intérieure de l'ouverture soit délimitée au moins en partie par la, ou les, deuxièmes couches.

Selon une mise en oeuvre, le premier tronçon est obtenu par croissance axiale et le deuxième tronçon est obtenu par croissance axiale et/ou radiale.

Selon une mise en oeuvre particulière, le procédé comporte les étapes successives suivantes :
- former à partir du substrat une amorce du nanofil semi-conducteur comprenant au moins le premier tronçon, notamment à partir d'une étape de gravure du substrat,
- former le miroir autour de l'amorce,
- former le reste du nanofil semi-conducteur par croissance, notamment axiale et/ou radiale, à partir de l'amorce, de préférence à partir d'une extrémité de l'amorce en saillie d'une surface extérieure du miroir.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en coupe d'un agencement selon un mode d'exécution particulier,
- la figure 2 illustre une variante du mode d'exécution de la figure 1,
- la figure 3 illustre la variation du coefficient de réflexion d'un miroir en fonction du diamètre normalisé d'un nanofil pour différents diamètres de trous du miroir à partir duquel s'étend le nanofil,
- la figure 4 illustre la variation du coefficient de réflexion d'un miroir en fonction du diamètre normalisé d'un nanofil pour différentes épaisseurs d'une couche tampon du miroir,
- les figures 5 à 10 illustrent, vues en coupe, différentes étapes d'un procédé de fabrication d'un agencement.

### Description de modes préférentiels de l'invention

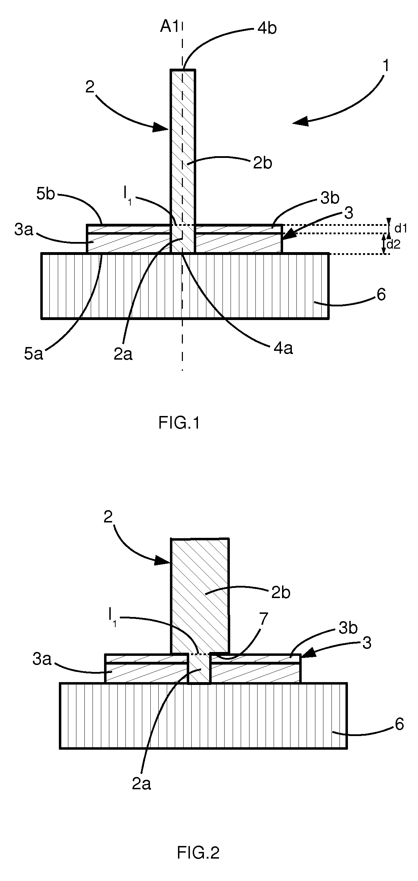

Le présent agencement optoélectronique présente un miroir qui entoure un tronçon du nanofil semi-conducteur situé entre ses deux extrémités longitudinales opposées. Comme illustré à la figure 1, l'agencement optoélectronique 1 comprend un nanofil semi-conducteur 2 destiné à participer au traitement d'une lumière considérée.

Par « traitement d'une lumière considérée », on entend que le nanofil semi-conducteur 2 peut participer à une réception (par exemple dans le cadre d'une utilisation du nanofil semi-conducteur 2 dans une cellule photovoltaïque) et/ou une émission (par exemple dans le cadre d'une utilisation du nanofil semi-conducteur 2 dans une diode électroluminescente) de la lumière considérée. Typiquement, le nanofil semi-conducteur 2 pourra être dopé électriquement, en tout ou partie, d'un premier type, notamment de type p, et formera au moins en partie une jonction p/n d'une diode électroluminescente ou d'une photodiode.

Avantageusement, le nanofil semi-conducteur 2 est formé dans un, ou plusieurs, matériau(x) semi-conducteur(s) appartenant par exemple aux familles (Si, Ge) ou III-V (comme GaAs, InAs, GaP InP, GaSb, GaN, AIN, InN) ou II-VI (comme CdTe, CdSe, ZnTe, ZnSe, ZnO, MgO) ainsi que leurs alliages.

Par ailleurs, l'agencement comporte un miroir 3 réfléchissant à la lumière considérée. Le nanofil semi-conducteur 2 comportant un premier tronçon 2a et un deuxième tronçon 2b, le miroir 3 entoure au moins longitudinalement le premier tronçon 2a du nanofil semi-conducteur 2, ledit deuxième tronçon 2b s'étendant hors du miroir 3.

Plus particulièrement, le nanofil semi-conducteur 2 s'étend entre deux extrémités longitudinales opposées 4a et 4b du nanofil semi-conducteur 2, et le deuxième tronçon 2b est en continuité du premier tronçon 2a. En fait, la limite entre le premier tronçon 2a et le deuxième tronçon 2b est représentée par la ligne en pointillés l₁ de la figure 1.

Par le fait que « le miroir 3 entoure au moins longitudinalement le premier tronçon 2a du nanofil semi-conducteur 2 », on entend que le miroir possède une ouverture débouchante au sein de laquelle le premier tronçon 2a est disposé.

Sur la figure 1, l'ouverture du miroir 3 est débouchante et est comblée en tout ou partie par le premier tronçon 2a de sorte que le miroir 3 forme une gaine autour du nanofil semi-conducteur 2 au niveau du premier tronçon 2a. L'extrémité 4a du nanofil semi-conducteur 2, délimitée par une partie du premier tronçon 2a est avantageusement en contact avec un substrat 6 au niveau d'une première face 5a du miroir 3. Le deuxième tronçon 2b s'étend d'une deuxième face 5b du miroir 3, dite face réfléchissante du miroir 3, opposée à la première face 5a.

Par « ouverture comblée en tout ou partie par le premier tronçon 2a », on entend que les dimensions latérales du premier tronçon 2a peuvent être inférieures ou égales aux dimensions latérales de l'ouverture. Autrement dit, entre les deux extrémités 4a, 4b du nanofil semi-conducteur 2, le miroir 3 entoure le premier tronçon 2a avec ou sans contact (sur la figure 1, le miroir 3 est en contact avec le premier tronçon 2a entre les deux extrémités 4a et 4b du nanofil semi-conducteur 2).

A la figure 1, les dimensions latérales, ou le cas échéant le diamètre, de l'ouverture et du premier tronçon 2a sont orientés sensiblement perpendiculairement à l'axe A1.

Le nanofil semi-conducteur 2 est avantageusement une structure verticale par rapport au miroir qui est considéré comme une structure planaire.

L'ouverture du miroir 3 comblée en tout ou partie par le premier tronçon 2a présente des dimensions latérales d'ouverture inférieures à λ/5n avec n l'indice de réfraction du premier tronçon 2a du nanofil semi-conducteur 2, et λ la longueur d'onde de la lumière considérée. Avantageusement, l'ouverture présente une section en forme de disque, dès lors on considère que le diamètre de l'ouverture est inférieur à λ/5n. Ces dimensions permettent d'éviter à la lumière considérée de fuir par l'ouverture au niveau du miroir et d'être perdue.

De préférence, les dimensions latérales, ou le cas échéant le diamètre de l'ouverture, sont comprises entre 5nm et 30nm.

De préférence, l'agencement comporte un substrat 6 sur lequel repose le miroir 3.

Préférentiellement, le nanofil semi-conducteur 2 s'étend, via son premier tronçon 2a, à partir dudit substrat 6 (figure 1). Cette géométrie permet d'obtenir un agencement compact tout en procurant une bonne assise du nanofil semi-conducteur 2 au niveau du miroir 3. On comprend alors que l'extrémité 4a du nanofil semi-conducteur 2 est en contact avec le substrat 6, et que l'extrémité 4b du nanofil semi-conducteur 2 est distale du substrat 6 du fait que le nanofil semi-conducteur 2 s'étend, à partir de son extrémité 4a, dans une direction opposée au substrat 6.

Selon une mise en oeuvre particulière préférée mais optionnelle, le miroir 3 comporte une couche réfléchissante 3a à la lumière considérée. De préférence, la couche réfléchissante 3a comprend (ou est constituée par) un matériau dont le coefficient de réflexion en intensité, à la longueur d'onde considérée et pour une onde plane en incidence normale, est supérieur ou égal à 60% comme par exemple l'or, l'aluminium, le cuivre ou l'argent. Afin d'augmenter la réflectivité, le miroir 3 peut comporter en outre une couche tampon 3b transparente à la lumière considérée. Cette couche tampon 3b est, de préférence, disposée au niveau de l'interface entre le premier tronçon 2a et le deuxième tronçon 2b. De préférence, la couche tampon 3b est en matériau diélectrique comprenant du SiO₂ ou du Si₃N₄. Alternativement, la couche tampon 3b est en un matériau transparent conducteur électriquement tel que l'oxyde de zinc ou l'oxyde d'indium-étain (aussi connu sous l'acronyme ITO dans le domaine). L'épaisseur de cette couche tampon 3b est de préférence telle qu'elle supprime l'excitation plasmonique de la couche réfléchissante 3a lorsqu'elle est atteinte par la lumière considérée. De préférence, l'épaisseur d₁ de la couche tampon 3b est comprise entre 2nm et 20nm, et l'épaisseur d₂ de la couche réfléchissante 3a est supérieure à 30nm.

La couche réfléchissante 3a peut être formée d'un empilement d'une, ou plusieurs, sous-couches de natures identiques ou différentes.

Comme illustré à la figure 1, la couche réfléchissante 3a est disposée entre le substrat 6 et la couche tampon 3b. En effet, elle doit être placée au niveau de la face réfléchissante recevant la lumière considérée à réfléchir.

Selon une réalisation particulière illustrée à la figure 1, les sections transversales des premier et deuxième tronçons 2a, 2b sont sensiblement identiques. Autrement dit, entre les deux extrémités longitudinales opposées 4a et 4b du nanofil semi-conducteur 2, la section transversale dudit nanofil semi-conducteur 2 reste sensiblement constante.

Selon une autre réalisation particulière illustrée à la figure 2 qui reprend les mêmes éléments que la figure 1 (de préférence, tout ce qui a été dit ci-avant peut s'appliquer à cette figure 2), le deuxième tronçon 2b, disposé dans la continuité du premier tronçon 2a, présente une section transversale dont la surface est supérieure à la surface de la section transversale du premier tronçon 2a de sorte à former un épaulement 7 avec ledit premier tronçon 2a. Autrement dit, au niveau de la ligne l₁, la jonction entre le premier tronçon 2a et le deuxième tronçon 2b forme un épaulement 7 de sorte que le nanofil semi-conducteur 2 est plus élargi au niveau de son deuxième tronçon 2b qu'au niveau de son premier tronçon 2a. L'avantage d'un tel nanofil semi-conducteur 2 est de permettre d'éviter les fuites de lumière à sa base au niveau du miroir tout en procurant au niveau de son deuxième tronçon 2b une surface extérieure plus grande à fonctionnaliser dans le cadre de la formation d'une jonction p/n par exemple. De cette manière, on peut ainsi réaliser des jonctions p/n latérales (par exemple pour les diodes électroluminescentes ou les cellules photovoltaïques). Il est aussi possible de jouer sur le diamètre du nanofil semi-conducteur 2 pour contrôler les modes optiques guidés par ledit nanofil semi-conducteur 2 (crucial pour certaines applications, notamment pour former une source de photon unique). Par ailleurs, la section transversale du deuxième tronçon 2b au niveau de son interface avec le miroir 3 peut présenter des dimensions supérieures à celles de l'ouverture du miroir 3 comblée en tout ou partie par le premier tronçon 2a.

La section du tronçon 2b peut aussi varier par exemple continument entre sa valeur au niveau du miroir et sa valeur (plus grande ou plus petite) à son extrémité libre. Le nanofil semi-conducteur 2 peut aussi présenter tout autre profil.

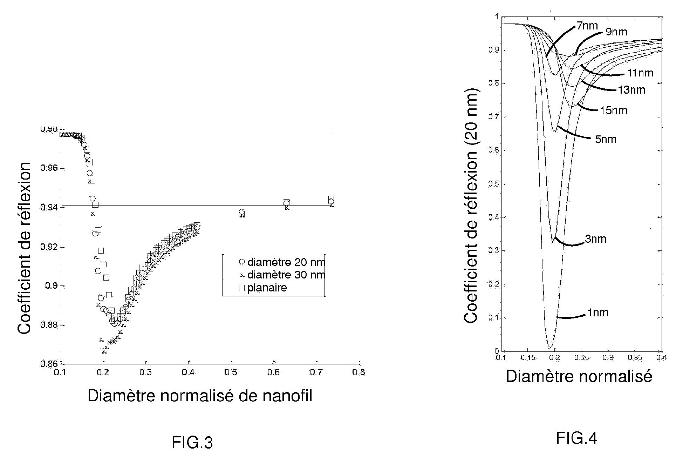

La figure 3 montre le coefficient de réflexion d'un mode guidé pour un nanofil unique de GaAs sur un miroir constitué par une couche réfléchissante d'or de 100 nm d'épaisseur, recouverte d'une couche tampon en silice de 9 nm d'épaisseur, en fonction du diamètre normalisé d/*λ du tronçon 2b* du nanofil considéré comme cylindrique. Le calcul est fait pour un miroir sans ouverture (cas « planaire »), et pour les cas où l'ouverture a un diamètre de 20 nm ou de 30 nm et est entièrement remplie par le premier tronçon 2a du nanofil semi-conducteur 2 (comme sur la figure 2). On notera que ce miroir offre une bonne réflexion du mode guidé quel que soit le diamètre du nanofil semi-conducteur, et que la présence d'une ouverture n'affecte pas celle-ci de façon majeure. On peut montrer que ce résultat reste vrai tant que la taille de l'ouverture est suffisamment petite, typiquement inférieure à λ/(5n). Ainsi, l'agencement permet une bonne réflexion tout en étant plus compact et facile à fabriquer.

La figure 4 illustre quant à elle l'importance de la couche 3b en matériau diélectrique. Elle présente le coefficient de réflexion du mode guidé du nanofil pour différentes épaisseurs de la couche tampon, et pour une taille d'ouverture de 20 nm, en fonction du diamètre du nanofil semi-conducteur pour une couche 3a en or de 100nm d'épaisseur. Chaque courbe est associée à une épaisseur correspondante de la couche tampon (respectivement 1nm, 3nm, 5nm, 7nm, 9nm, 11 nm, 13nm et 15nm). En l'absence de couche tampon ou si celle-ci est trop fine (1 nm), le coefficient de réflexion est très faible pour d/λ d'environ 0.25, du fait du couplage aux modes plasmons de surface de la couche réfléchissante. Une épaisseur adaptée de la couche tampon, ici 9 nm, permet a contrario d'obtenir un coefficient de réflexion très élevé (R>0.85) quel que soit le diamètre du nanofil semi-conducteur.

Dans les exemples des figures 3 et 4, λ était fixé à 1µm.

De manière applicable à tout ce qui a été dit ci-dessus, le substrat 6 et au moins la base du nanofil semi-conducteur 2 en contact avec le substrat 6 sont avantageusement dopés électriquement d'un même type. Ceci permet de fonctionnaliser l'agencement en utilisant le substrat 6 comme élément de contact électrique, notamment au niveau d'une face arrière du substrat 6 opposée à la face du substrat sur laquelle le miroir 3 est disposé.

Le substrat 6 peut être en silicium monocristallin, en matériau III-V comme GaAs, en saphir, ou dans un matériau à plus faible coût comme le Si polycristallin ou un alliage métallique.

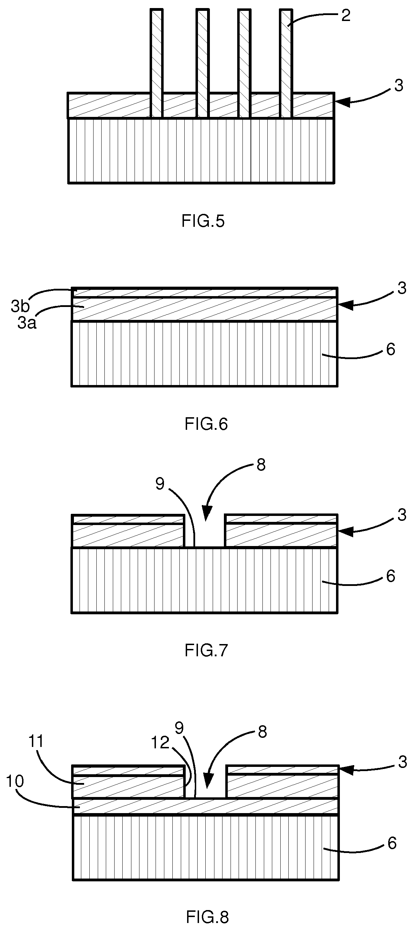

L'invention est aussi relative à un dispositif optoélectronique qui comporte une pluralité d'agencements tel que décrits. Un tel dispositif est aussi connu dans le domaine sous le nom de tapis de nanofils semi-conducteurs 2. De préférence, les agencements partagent un même miroir 3 (figure 5). Par ailleurs, chaque nanofil semi-conducteur 2 est couplé à des moyens (non représentés) permettant, avec ledit nanofil semi-conducteur 2, d'émettre ou de recevoir la lumière considérée. Notamment ces moyens peuvent former avec chacun des nanofils semi-conducteurs 2 une jonction p/n.

On comprend alors que le dispositif optoélectronique peut être une cellule photovoltaïque, un afficheur à diodes électroluminescentes, ou tout autre type de dispositif optoélectronique apte à prendre parti de l'émission ou de la réception d'une lumière considérée.

Dans le cas de l'émission de la lumière considérée, cette dernière est générée à partir de chaque nanofil semi-conducteur et le miroir permet d'augmenter l'efficacité d'émission en limitant les pertes de rayonnement par échappement vers le substrat et/ou permet de rendre l'émission plus directive.

Dans le cas de la réception/détection de la lumière considérée, toute la lumière n'ayant pas été prise en compte dans un premier temps par les nanofils semi-conducteurs vient toucher le miroir de sorte à être réfléchie dans un second temps au moins en direction des nanofils semi-conducteurs, il en résulte que la quantité de rayonnement absorbé est magnifiée.

Dans le cadre du dispositif optoélectronique présentant un réseau dense de nanofils en GaAs sur un substrat en GaAs (notamment utile dans le cadre des applications de diode électroluminescente ou de cellule photovoltaïque), en l'absence du miroir la réflexion procurée par la surface du substrat est inférieure à (n-1)²/(n+1)²=0.3, où n désigne l'indice de réfraction du substrat à la longueur d'onde concernée (ici 1µm), alors que la présence du miroir permet d'obtenir une réflectivité supérieure à 90% pour une large gamme de diamètre des nanofils (diamètre du nanofil inférieur à 150 nm dans le cas de l'exemple). Par « réseau dense », on entend ici plus d'un nanofil par µm².

L'invention est aussi relative à un procédé de fabrication d'un agencement optoélectronique ou d'un dispositif optoélectronique tel que décrit. Notamment ce procédé comporte une étape de réalisation d'un miroir 3 (figure 6), et une étape de formation du nanofil semi-conducteur 2 de sorte qu'un premier tronçon 2a du nanofil semi-conducteur 2 soit entouré au moins longitudinalement par le miroir 3, et qu'un deuxième tronçon 2b du nanofil semi-conducteur 2 s'étende hors du miroir 3 (figures 1 et 2).

L'étape de formation du nanofil semi-conducteur 2 et/ou l'étape de réalisation du miroir 3 peuvent être configurées de sorte à former les différentes réalisations de l'agencement, ou du dispositif, décrites ci-avant.

De préférence, le procédé comporte une étape de fourniture d'un substrat 6 et le miroir 3 est réalisé sur ledit substrat 6 (figure 6).

Selon une réalisation, le procédé comporte la formation d'une ouverture 8 dans le miroir 3 (figures 7 et 8), l'étape de formation du nanofil semi-conducteur 2 étant réalisée par croissance, notamment par épitaxie, à partir de l'ouverture 8.

De préférence, l'ouverture 8 est formée de sorte à présenter un fond 9 délimité par le substrat 6 (figure 7), ou par une partie du miroir (figure 8), la croissance du nanofil semi-conducteur 2 étant réalisée au moins à partir dudit fond 9. Consécutivement à la croissance, le nanofil semi-conducteur 2 obtenu est en contact avec le substrat 6 (le cas échéant la partie du miroir se retrouve au sommet 4b du nanofil semi-conducteur 2 opposé au substrat 6)

Selon une exécution particulière (figure 8), l'étape de formation du miroir 3 est réalisée avant l'étape de formation du nanofil semi-conducteur 2 et comporte le dépôt d'une première couche 10 d'un matériau apte à catalyser la croissance du nanofil 2 semi-conducteur et le dépôt d'une ou plusieurs deuxièmes couches 11 sur la première couche de sorte que le fond 9 de l'ouverture 8 soit formé par une partie de la première couche 10 et que la paroi latérale intérieure 12 de l'ouverture 8 soit délimitée au moins en partie par la, ou les, deuxièmes couches 11. La première couche 10 peut par exemple être en or dans le but de catalyser la croissance d'un nanofil en silicium ou en matériau semi-conducteur II-VI comme CdTe ou ZnTe.

Par ailleurs, l'étape de formation du miroir 3 peut avantageusement comporter une étape de formation de la couche réfléchissante 3a (telle que décrite ci-avant) sur le substrat 6 et une étape de formation de la couche tampon 3b (telle que décrite ci-avant) sur la couche réfléchissante 3a (figure 6).

Il est entendu que le miroir 3 et l'ouverture 8 peuvent être formés :
- par dépôt du miroir puis par gravure du miroir 3 afin de former l'ouverture 8 (après dépôt du miroir une couche de résine est déposée, une étape de lithographie permet ensuite de définir une ou plusieurs ouvertures dans la résine, qui est ensuite transférée par gravure dans l'empilement formant le miroir),
- par formation d'un masque dur, puis dépôt du miroir avant de retirer le masque dur (dans ce cas le substrat est couvert d'une couche de résine, insolée puis révélée de façon à laisser des plots de résine à la future position de la ou des ouvertures. On dépose ensuite l'empilement désiré formant le miroir et on termine la fabrication via une étape bien connue de « lift-off »),
- par utilisation de la nanoimpression,
- par structuration spontanée d'un film de copolymère à blocs.

La synthèse du nanofil, notamment semiconducteur et avantageusement dopé électriquement, peut ensuite être réalisée à partir de l'ouverture 8 à l'aide de différentes méthodes de croissance épitaxiale telles que l'épitaxie en phase vapeur à partir d'organométalliques (EPVOM), l'épitaxie par jets moléculaires (EJM) ou, pour certains matériaux comme ZnO, par synthèse hydrothermale à basse température.

Selon les matériaux et les techniques utilisés, la croissance sera ou non assistée par un catalyseur. Toute méthode connue pour la croissance des nanofils semi-conducteurs est potentiellement compatible avec l'emploi du miroir 3 tel que décrit.

A titre d'exemple, l'or est traditionnellement employé pour la croissance par EPVOM de nanofils de Si. Ce catalyseur sera apporté dans ce cas par la première couche 10, et la gravure du miroir 3 sera conduite de façon à conserver dans ce cas la couche première couche 10. Au cours de la croissance, l'or présent initialement en fond de l'ouverture 8 constitue une petite goutte qui reste au sommet du nanofil. Le reste du miroir 3 est choisi de façon à rester inerte au cours de la croissance, tout en ayant de bonnes propriétés optiques (par exemple l'aluminium est un bon choix).

Alternativement, un nanofil en GaN peut être obtenu sans élément catalyseur additionnel, en EJM comme en EPVOM. Dans ce cas, le miroir sera en matériaux inertes vis-à-vis de la croissance du nanofil, et on obtiendra une épitaxie sélective du nanofil dans l'ouverture du miroir.

Une fois que la croissance du nanofil semi-conducteur est suffisante pour qu'il sorte du trou, on peut réaliser une hétérostructure radiale et/ou axiale de ce nanofil semi-conducteur.

De manière générale applicable aux différentes réalisations du procédé, le premier tronçon 2a du nanofil semi-conducteur 2 est obtenu par croissance axiale et le deuxième tronçon 2b du nanofil semi-conducteur 2 est obtenu par croissance axiale et/ou radiale.

Par « croissance axiale », on entend que le nanofil semi-conducteur accroît sa longueur sans augmenter son diamètre (ou ses dimensions latérales), ou accroît sa longueur beaucoup plus rapidement (plus de dix fois plus vite) que son diamètre (ou ses dimensions latérales). Cette croissance axiale permet de moduler la nature, composition ou dopage du semiconducteur obtenu par croissance axiale du nanofil semi-conducteur et de définir selon l'axe du nanofil semi-conducteur passant par ses deux extrémités longitudinales opposées des barrières ou des boîtes quantiques.

Par « croissance radiale », on entend que le nanofil semi-conducteur croît en diamètre (ou en dimensions latérales) de une à dix fois plus vite qu'en longueur, c'est-à-dire qu'il ne croît pas ou peu en longueur. Cette croissance radiale permet de définir des puits quantiques latéraux ou encore des jonctions p/n radiales.

Lors de l'étape de croissance du nanofil semi-conducteur 2, il est possible de basculer d'une croissance (radiale/axiale) à l'autre en jouant sur les conditions de croissance, afin de fabriquer des structures plus complexes. A titre d'exemple, des sources de photon unique à fil photonique ont été fabriquées en définissant une boîte quantique par croissance axiale, puis en utilisant une étape de croissance radiale pour l'intégrer dans un guide d'onde cylindrique de taille contrôlée. L'homme du métier sera donc apte à mettre en oeuvre une croissance idoine du nanofil semi-conducteur en fonction du dispositif optoélectronique souhaité.

Dans les exemples précédents, il est utilisé des métaux adaptés de par leurs propriétés optiques à la fabrication du miroir, et inertes au cours de la croissance du nanofil semi-conducteur. Si de tels matériaux n'existent pas à cause d'un choix fixé de l'un d'entre eux, ou si on veut simplement limiter au maximum la contamination des nanofils semi-conducteurs par les matériaux constituant le miroir lors de leurs croissances, on utilisera de façon préférentielle une stratégie alternative.

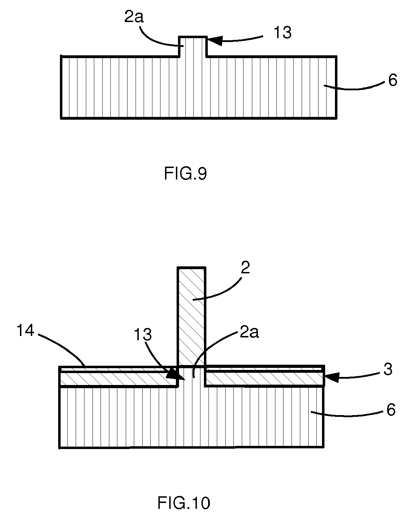

Dans cette stratégie alternative, le procédé comporte les étapes successives suivantes :
- former à partir du substrat 6 une amorce 13 du nanofil semi-conducteur 2 comprenant au moins le premier tronçon 2a, notamment à partir d'une étape de gravure du substrat 6 (figure 9),
- former le miroir 3 autour de l'amorce 13 (figure 10),
- former le reste du nanofil semi-conducteur 2 par croissance (figure 10), notamment axiale et/ou radiale, à partir de l'amorce 13, de préférence à partir d'une extrémité de l'amorce en saillie d'une surface extérieure 14 du miroir 3.

La surface extérieure 14 du miroir 13 est destinée à être disposée en regard de la lumière considérée. Autrement dit, la surface extérieure 14 est opposée au substrat 6. On comprend alors que dans l'agencement, le premier tronçon 2a peut être formé en tout ou partie par une partie du substrat 6.

Il est entendu que tous les matériaux visés ci-avant dans le cadre de l'agencement optoélectronique peuvent être utilisés dans le cadre du procédé dans le but de former un élément de l'agencement auquel ils sont associés.

Le procédé décrit ci-avant peut aussi permettre de fabriquer une pluralité d'agencements partageant un même miroir (formant ainsi le dispositif optoélectronique). Dans ce cas les ouvertures au sein de ce miroir ou les amorces réalisées avant de former le miroir, permettent de former tout ou partie des nanofils semi-conducteurs en utilisant les ouvertures comme masque de croissance des nanofils ou les amorces comme point de départ de la croissance du reste des nanofils semi-conducteurs. Ainsi, il résulte une grande reproductibilité dans le sens où les nanofils semi-conducteurs ne croissent pas de manière aléatoire mais au niveau de sites privilégiés parfaitement définis.

Un des nombreux avantages du procédé tel que décrit est de permettre une croissance du nanofil semi-conducteur au niveau du miroir, évitant ainsi le report de la structure à nanofils sur un autre substrat comme dans l'art antérieur. Il en résulte que ce procédé peut être mis en oeuvre en baissant significativement les coûts de fabrication tout en favorisant la reproductibilité.

## Revendications

1. Agencement optoélectronique (1) comprenant un nanofil semi-conducteur (2) destiné à participer au traitement, notamment à une réception et/ou une émission, d'une lumière considérée et un miroir (3) réfléchissant à la lumière considérée, le nanofil semi-conducteur (2) comportant un premier tronçon (2a) et un deuxième tronçon (2b), ledit miroir (3) entourant au moins longitudinalement le premier tronçon (2a) du nanofil semi-conducteur (2), ledit deuxième tronçon (2b) s'étendant hors du miroir (3), **caractérisé en ce que** :
- une ouverture du miroir (3) comblée en tout ou partie par le premier tronçon (2a) présente des dimensions latérales d'ouverture inférieures à λ/5n avec n l'indice de réfraction du matériau du premier tronçon (2a) du nanofil semi-conducteur (2), et λ la longueur d'onde de la lumière considérée,
- le miroir (3) repose sur un substrat (6) et comporte une couche réfléchissante (3a) à la lumière considérée et une couche tampon (3b) transparente à la lumière considérée augmentant la réflectivité du miroir (3), la couche réfléchissante (3a) étant disposée entre le substrat (6) et la couche tampon (3b).

2. Agencement selon la revendication précédente, caractérisé en ce la couche réfléchissante (3a) comprend un matériau dont le coefficient de réflexion en intensité, à la longueur d'onde considérée et pour une onde plane en incidence normale, est supérieur ou égal à 60% comme par exemple l'or, l'aluminium, le cuivre ou l'argent.

3. Agencement selon l'une quelconque des revendications précédentes, **caractérisé en ce que** le nanofil semi-conducteur (2) s'étend, via son premier tronçon (2a), à partir dudit substrat (6).

4. Agencement selon l'une quelconque des revendications précédentes, **caractérisé en ce que** la couche tampon (3b) est en matériau diélectrique comprenant du SiO₂ ou du Si₃N₄, ou en matériau transparent conducteur électriquement tel que l'oxyde d'indium-étain ou l'oxyde de zinc.

5. Agencement selon l'une des revendications précédentes, **caractérisé en ce que** la couche réfléchissante (3a) présente une épaisseur supérieure à 30nm, et **en ce que** la couche tampon (3b) présente une épaisseur comprise entre 2nm et 20nm.

6. Agencement selon l'une quelconque des revendications précédentes, **caractérisé en ce que** les sections transversales des premier et deuxième tronçons (2a, 2b) sont sensiblement identiques.

7. Agencement selon l'une quelconque des revendications 1 à 5, **caractérisé en ce que** le deuxième tronçon (2b), disposé dans la continuité du premier tronçon (2a), présente une section transversale dont la surface est supérieure à la surface de la section transversale du premier tronçon (2a) de sorte à former un épaulement (7) avec ledit premier tronçon (2a).

8. Agencement selon la revendication précédente, **caractérisé en ce que** la section transversale du deuxième tronçon (2b) au niveau de son interface avec le miroir (3) présente des dimensions supérieures à celles de l'ouverture du miroir (3) comblée en tout ou partie par le premier tronçon (2a).

9. Dispositif optoélectronique, **caractérisé en ce qu'**il comporte une pluralité d'agencements selon l'une quelconque des revendications précédentes, notamment partageant un même miroir (3), et **en ce que** chaque nanofil semi-conducteur (2) est couplé à des moyens permettant, avec ledit nanofil semi-conducteur (2), d'émettre ou de recevoir la lumière considérée.

10. Procédé de fabrication d'au moins un agencement selon l'une quelconque des revendications 1 à 8, **caractérisé en ce qu'**il comporte les étapes suivantes :
- la fourniture d'un substrat (6),
- la réalisation du miroir (3) sur ledit substrat (6),
- la formation du nanofil semi-conducteur (2) de sorte que le premier tronçon (2a) du nanofil semi-conducteur (2) soit entouré au moins longitudinalement par le miroir (3), et que le deuxième tronçon (2b) du nanofil semi-conducteur (2) s'étende hors du miroir (3).

11. Procédé selon la revendication 10, **caractérisé en ce qu'**il comporte la formation d'une ouverture (8) dans le miroir (3), l'étape de formation du nanofil semi-conducteur (2) étant réalisée par croissance, notamment par épitaxie, à partir de l'ouverture (8).

12. Procédé selon la revendication 11, **caractérisé en ce que** l'ouverture (8) est formée de sorte à présenter un fond (9) délimité par le substrat (6), ou par une partie du miroir (3), la croissance du nanofil semi-conducteur (2) étant réalisée à partir dudit fond (9).

13. Procédé selon la revendication précédente, **caractérisé en ce que** l'étape de formation du miroir (3), réalisée avant l'étape de formation du nanofil semi-conducteur (2), comporte le dépôt d'une première couche (10) d'un matériau apte à catalyser la croissance du nanofil semi-conducteur (2) et le dépôt d'une ou plusieurs deuxièmes couches (11) sur la première couche (10) de sorte que le fond (9) de l'ouverture (8) soit formé par une partie de la première couche (10) et que la paroi latérale intérieure (12) de l'ouverture (8) soit délimitée au moins en partie par la, ou les, deuxièmes couches (11).

14. Procédé selon l'une quelconque des revendications 10 à 13, **caractérisé en ce que** le premier tronçon (2a) est obtenu par croissance axiale et **en ce que** le deuxième tronçon (2b) est obtenu par croissance axiale et/ou radiale.

15. Procédé selon la revendication 10, **caractérisé en ce qu'**il comporte les étapes successives suivantes :
- former à partir du substrat (6) une amorce (13) du nanofil semi-conducteur (2) comprenant au moins le premier tronçon (2a), notamment à partir d'une étape de gravure du substrat (6),
- former le miroir (3) autour de l'amorce (13),
- former le reste du nanofil semi-conducteur (2) par croissance, notamment axiale et/ou radiale, à partir de l'amorce (13), de préférence à partir d'une extrémité de l'amorce (13) en saillie d'une surface extérieure (14) du miroir (3).

## Patentansprüche

1. Optoelektronische Anordnung (1), die einen Halbleiter-Nanodraht (2), der dazu bestimmt ist, bei der Verarbeitung, insbesondere bei einem Empfang und/oder einer Aussendung, eines betrachteten Lichtes mitzuwirken, und einen Spiegel (3), der das betrachtete Licht reflektiert, aufweist, wobei der Halbleiter-Nanodraht (2) einen ersten Abschnitt (2a) und einen zweiten Abschnitt (2b) aufweist, wobei der Spiegel (3) wenigstens in Längsrichtung den ersten Abschnitt (2a) des Halbleiter-Nanodrahtes (2) umgibt, wobei sich der zweite Abschnitt (2b) außerhalb des Spiegels (3) erstreckt, **dadurch gekennzeichnet, dass**:
- eine Öffnung des Spiegels (3), die ganz oder teilweise von dem ersten Abschnitt (2a) ausgefüllt wird, seitliche Öffnungsabmessungen aufweist, die kleiner als λ/5n sind, wobei n der Brechungsindex des Materials des ersten Abschnitts (2a) des Halbleiter-Nanodrahtes (2) ist und λ die Wellenlänge des betrachteten Lichtes ist,
- der Spiegel (3) auf einem Substrat (6) ruht und eine das betrachtete Licht reflektierende Schicht (3a) und eine für das betrachtete Licht durchlässige Pufferschicht (3b), welche den Reflexionsgrad des Spiegels (3) erhöht, aufweist, wobei die reflektierende Schicht (3a) zwischen dem Substrat (6) und der Pufferschicht (3b) angeordnet ist.

2. Anordnung nach dem vorhergehenden Anspruch, **dadurch gekennzeichnet, dass** die reflektierende Schicht (3a) ein Material umfasst, dessen Intensitätsreflexionskoeffizient, bei der betrachteten Wellenlänge und für eine normal einfallende ebene Welle, größer oder gleich 60 % ist, wie zum Beispiel Gold, Aluminium, Kupfer oder Silber.

3. Anordnung nach einem der vorhergehenden Ansprüche, **dadurch gekennzeichnet, dass** sich der Halbleiter-Nanodraht (2), über seinen ersten Abschnitt (2a), von dem Substrat (6) aus erstreckt.

4. Anordnung nach einem der vorhergehenden Ansprüche, **dadurch gekennzeichnet, dass** die Pufferschicht (3b) aus dielektrischem Material besteht, welches SiO₂ oder Si₃N₄ umfasst, oder aus elektrisch leitendem durchsichtigem Material, wie etwa Indiumzinnoxid oder Zinkoxid.

5. Anordnung nach einem der vorhergehenden Ansprüche, **dadurch gekennzeichnet, dass** die reflektierende Schicht (3a) eine Dicke von mehr als 30 nm aufweist, und dadurch, dass die Pufferschicht (3b) eine Dicke zwischen 2 nm und 20 nm aufweist.

6. Anordnung nach einem der vorhergehenden Ansprüche, **dadurch gekennzeichnet, dass** die Querschnitte des ersten und des zweiten Abschnitts (2a, 2b) im Wesentlichen identisch sind.

7. Anordnung nach einem der Ansprüche 1 bis 5, **dadurch gekennzeichnet, dass** der zweite Abschnitt (2b), der an den ersten Abschnitt (2a) anschließend angeordnet ist, einen Querschnitt aufweist, dessen Fläche größer als die Fläche des Querschnitts des ersten Abschnitt (2a) ist, so dass er mit dem ersten Abschnitt (2a) eine Schulter (7) bildet.

8. Anordnung nach dem vorhergehenden Anspruch, **dadurch gekennzeichnet, dass** der Querschnitt des zweiten Abschnitts (2b) an seiner Grenzfläche mit dem Spiegel (3) Abmessungen aufweist, die größer als diejenigen der ganz oder teilweise von dem ersten Abschnitt (2a) ausgefüllten Öffnung des Spiegels (3) sind.

9. Optoelektronische Vorrichtung, **dadurch gekennzeichnet, dass** sie mehrere Anordnungen nach einem der vorhergehenden Ansprüche aufweist, die insbesondere ein und denselben Spiegel (3) gemeinsam haben, und dadurch, dass jeder Halbleiter-Nanodraht (2) mit Mitteln gekoppelt ist, die es ermöglichen, mit diesem Halbleiter-Nanodraht (2) das betrachtete Licht auszusenden oder zu empfangen.

10. Verfahren zur Herstellung wenigstens einer Anordnung nach einem der Ansprüche 1 bis 8, **dadurch gekennzeichnet, dass** es die folgenden Schritte aufweist:
- die Bereitstellung eines Substrats (6),
- die Herstellung eines Spiegels (3) auf dem Substrat (6),
- die Ausbildung des Halbleiter-Nanodrahtes (2), derart, dass der erste Abschnitt (2a) des Halbleiter-Nanodrahtes (2) wenigstens in Längsrichtung von dem Spiegel (3) umgeben ist, und dass sich der zweite Abschnitt (2b) des Halbleiter-Nanodrahtes (2) außerhalb des Spiegels (3) erstreckt.

11. Verfahren nach Anspruch 10, **dadurch gekennzeichnet, dass** es die Ausbildung einer Öffnung (8) in dem Spiegel (3) aufweist, wobei der Schritt der Ausbildung des Halbleiter-Nanodrahtes (2) durch Aufwachsen, insbesondere durch Epitaxie, von der Öffnung (8) aus durchgeführt wird.

12. Verfahren nach Anspruch 11, **dadurch gekennzeichnet, dass** die Öffnung (8) derart ausgebildet wird, dass sie einen Boden (9) aufweist, der von dem Substrat (6) oder von einem Teil des Spiegels (3) begrenzt wird, wobei das Aufwachsen des Halbleiter-Nanodrahtes (2) von dem Boden (9) aus durchgeführt wird.

13. Verfahren nach dem vorhergehenden Anspruch, **dadurch gekennzeichnet, dass** der Schritt der Ausbildung des Spiegels (3), der vor dem Schritt der Ausbildung des Halbleiter-Nanodrahtes (2) durchgeführt wird, die Abscheidung einer ersten Schicht (10) eines Materials, das geeignet ist, das Aufwachsen des Halbleiter-Nanodrahtes (2) zu katalysieren, und die Abscheidung einer oder mehrerer zweiter Schichten (11) auf der ersten Schicht (10), derart, dass der Boden (9) der Öffnung (8) von einem Teil der zweiten Schicht (10) gebildet wird, und dass die innere Seitenwand (12) der Öffnung (8) wenigstens teilweise von der oder den zweiten Schichten (11) begrenzt wird, aufweist.

14. Verfahren nach einem der Ansprüche 10 bis 13, **dadurch gekennzeichnet, dass** der erste Abschnitt (2a) durch axiales Aufwachsen erhalten wird, und dadurch, dass der zweite Abschnitt (2b) durch axiales und/oder radiales Aufwachsen erhalten wird.

15. Verfahren nach Anspruch 10, **dadurch gekennzeichnet, dass** es die folgenden Schritte aufweist:
- Ausbilden, ausgehend von dem Substrat (6), eines Primers (13) des Halbleiter-Nanodrahtes (2), der wenigstens den ersten Abschnitt (2a) umfasst, insbesondere ausgehend von einem Schritt der Ätzung des Substrats (6),
- Ausbilden des Spiegels (3) um den Primer (13) herum,
- Ausbilden des restlichen Teils des Halbleiter-Nanodrahtes (2) durch Aufwachsen, insbesondere axiales und/oder radiales Aufwachsen, ausgehend von dem Primer (13), vorzugsweise von einem Ende des Primers (13), das von einer Außenfläche (14) des Spiegels (3) aus vorsteht.

## Claims

1. Optoelectronic arrangement (1) comprising a semiconductor nanowire (2) intended to participate in the processing, notably in a reception and/or an emission, of a light concerned and a mirror (3) reflecting the light concerned, the semiconductor nanowire (2) comprising a first section (2a) and a second section (2b), said mirror (3) surrounding at least longitudinally, the first section (2a) of the semiconductor nanowire (2), said second section (2b) extending out of the mirror (3), wherein :
- an aperture of the mirror (3) wholly or partly filled by the first section (2a) has lateral aperture dimensions less than λ/5n, with n being the refractive index of the material of the first section (2a) of the semiconductor nanowire (2), and λ being the wavelength of the light concerned,
- the mirror (3) rests on a substrate (6) and comprises a layer (3a) that is reflective to the light concerned and a buffer layer (3b) that is transparent to the light concerned increasing the reflectivity of the mirror (3), the reflecting layer (3a) being arranged between the substrate (6) and the buffer layer (3b).

2. Arrangement according to the preceding claim, **characterized in that** the reflecting layer (3a) comprises a material with a coefficient of reflection in terms of intensity, at the wavelength concerned and for a planar wave at normal incidence, that is greater than or equal to 60%, such as, for example, gold, aluminium, copper or silver.

3. Arrangement according to one of the preceding claims, **characterized in that** the semiconductor nanowire (2) extends, via its first section (2a), from said substrate (6).

4. Arrangement according to one of the preceding claims, **characterized in that** the buffer layer (3b) is made of a dielectric material comprising SiO₂ or Si₃N₄, or of an electrically conductive transparent material such as indium-tin oxide or zinc oxide.

5. Arrangement according to one of the preceding claims, **characterized in that** the reflecting layer (3a) has a thickness greater than 30 nm, and **in that** the buffer layer (3b) has a thickness between 2 nm and 20 nm.

6. Arrangement according to one of the preceding claims, **characterized in that** the cross sections of the first and second sections (2a, 2b) are substantially identical.

7. Arrangement according to one of Claims 1 to 5, **characterized in that** the second section (2b), arranged in continuity with the first section (2a), has a cross section whose surface area is greater than the surface area of the cross section of the first section (2a) so as to form a shoulder (7) with said first section (2a).

8. Arrangement according to the preceding claim, **characterized in that** the cross section of the second section (2b) at its interface with the mirror (3) has dimensions greater than those of the aperture of the mirror (3) wholly or partly filled by the first section (2a).

9. Optoelectronic device, **characterized in that** it comprises a plurality of arrangements according to one of the preceding claims, notably sharing one and the same mirror (3), and **in that** each semiconductor nanowire (2) is coupled to means that make it possible, with said semiconductor nanowire (2), to emit or receive the light concerned.

10. Method for fabricating at least one arrangement according to one of Claims 1 to 8, **characterized in that** it comprises the following steps:
- the provision of a substrate (6),
- the production of the mirror (3) on said substrate (6),
- the formation of the semiconductor nanowire (2) such that the first section (2a) of the semiconductor nanowire (2) is surrounded at least longitudinally by the mirror (3), and that the second section (2b) of the semiconductor nanowire (2) extends out of the mirror (3).

11. Method according to Claim 10, **characterized in that** it comprises the formation of an aperture (8) in the mirror (3), the step of formation of the semiconductor nanowire (2) being performed by growth, notably by epitaxy, from the aperture (8).

12. Method according to Claim 11, **characterized in that** the aperture (8) is formed in such a way as to have a bottom (9) delimited by the substrate (6), or by a part of the mirror (3), the growth of the semiconductor nanowire (2) being performed from said bottom (9).

13. Method according to the preceding claim, **characterized in that** the step of formation of the mirror (3), performed before the step of formation of the semiconductor nanowire (2), comprises the deposition of a first layer (10) of a material suitable for catalysing the growth of the semiconductor nanowire (2) and the deposition of one or more second layers (11) on the first layer (10) in such way that the bottom (9) of the aperture (8) is formed by a part of the first layer (10) and that the internal side wall (12) of the aperture (8) is delimited at least partly by the second layer or layers (11).

14. Method according to one of Claims 10 to 13, **characterized in that** the first section (2a) is obtained by axial growth and **in that** the second section (2b) is obtained by axial and/or radial growth.

15. Method according to Claim 10, **characterized in that** it comprises the following successive steps:
- forming, from the substrate (6), an initial section (13) of the semiconductor nanowire (2) comprising at least the first section (2a), notably from a step of etching of the substrate (6),
- forming the mirror (3) around the initial section (13),
- forming the rest of the semiconductor nanowire (2) by growth, notably axial and/or radial, from the initial section (13), preferably from an end of the initial section (13) protruding from an outer surface (14) of the mirror (3).
